## Europäisches Patentamt
## European Patent Office
## Office européen des brevets

(19)

(11) Publication number: **0 064 010**
A2

# EUROPEAN PATENT APPLICATION

(21) Application number: 82400751.2

(22) Date of filing: 27.04.82

(51) Int. Cl.³: **H 05 K 13/06,** H 05 K 13/04, H 01 L 21/48

(30) Priority: 27.04.81 US 258074

(43) Date of publication of application: 03.11.82
Bulletin 82/44

(84) Designated Contracting States: DE FR GB IT NL SE

(71) Applicant: **FAIRCHILD CAMERA & INSTRUMENT CORPORATION, 464 Ellis Street, Mountain View California 94042 (US)**

(72) Inventor: **Bowden, James E., 930 Rockfeller Drive, Sunnyvale California 94087 (US)**
Inventor: **Schneider, Mark R., 6948 Villagewood Way, San Jose California 95120 (US)**

(74) Representative: **Chareyron, Lucien et al, Schlumberger Limited Service Brevets 42, rue Saint-Dominique, F-75340 Paris Cedex 07 (FR)**

(54) **System and process for automatic wire welding.**

(57) This wire-welding electrode assembly, wire-welding system and wire-welding process utilizes the wire to be welded as one of the welding electrodes. The system and process provides a welded segment of wire between welding tabs and external terminals of an electronic circuit package with a ceramic substrate of the package assembled in its housing. Pivotal cutting blades are provided in the system for cutting the wire after it has been welded between two points. The system is preferably programmable to accommodate a variety of welding tab and terminal configurations in different packages.

JAMES E. BOWDEN
MARK R. SCHNEIDER

## "SYSTEM AND PROCESS FOR AUTOMATIC WIRE WELDING"

### CROSS REFERENCE TO RELATED APPLICATION:

This application and a concurrently filed application containing a common disclosure, by James E. Bowden, entitled "Electrode Assembly, System and Process for Automatic Wire Welding," contain claims to related inventions.

### BACKGROUND OF THE INVENTION:

#### 1. Field of the Invention

This invention relates to an improved electrode assembly for welding wire, especially wire used to interconnect portions of electronic packages. The invention also relates to an improved wire-welding system incorporating the electrode assembly. The invention further relates to a novel wire-welding process which may utilize the electrode assembly.

#### 2. Description of the Prior Art

As conventionally practiced in the prior art, wire welding is accomplished by placing a wire to be welded in physical contact with a conductive member to which the wire is to be welded. Positive and negative electrodes are then placed on the conductive member on either side of the wire and a welding current passed between the positive and negative electrodes to heat the conductive member and wire sufficiently to cause localized melting and consequent welding of the wire to the conductive member. While this technique is widely employed in the electronics industry for making contact between conductive pads on ceramic substrates

and external terminals of electronic packages, particularly hybrid electronic packages, a significant problem exists in the technique as conventionally practiced. The positive and negative electrodes tend to stick to the pads and terminals during the wire-welding processing.

The present approach to minimize the electrode sticking problem is to "dress" the positive and negative welding electrodes periodically with certain materials to inhibit their sticking. Typical procedures used to dress the electrode use a fine sandpaper or crocus cloth to give a highly polished, smooth and clean surface where the electrodes contact a workpiece. For high volume manufacturing applications, a separate set of electrodes is typically furnished for each weld required in a product, so that the relatively time-consuming operation of dressing the electrodes need only be performed once during each manufacturing shift, as a result of limiting the number of welds performed by each set of electrodes. The provision of separate sets of positive and negative electrodes for each weld required on a product adds materially to the complexity of the welding systems required and the manufacturing space they occupy. Further, while the provision of separate sets of electrodes for the very high volume production of a single, standard product may be economically feasible, applying this approach to a manufacturing environment in which different shaped electronic packages are to have wire-welded connections provided on them using the same wire-welding equipment is not economically practical.

0064010

## SUMMARY OF THE INVENTION

Accordingly, it is a general object of this invention to provide an electrode assembly and system for wire welding, which will eliminate the need for dressing the electrodes to prevent electrode sticking.

This and other objects are attained, in accordance with one aspect of the invention by a wire-welding system comprising: an electrode assembly which comprises an outer conductive sleeve having an axial passageway, and guide means for a wire in said axial passageway, said guide means electrically insulating the wire from said outer conductive sleeve, a welding circuit electrically connected to said electrically conductive sleeve and to the wire to be welded, the connection to the wire permitting the wire to be fed through said electrode assembly, means for positioning a member to which the wire is to be welded with respect to said electrode assembly, and means for supplying the wire to be welded for passage through said electrode assembly.

Another aspect of the invention includes a wire-welding process, comprising electrically connecting the wire to be welded as a first electrode in a welding circuit, positioning an end of said wire to be welded on a first conductive member to which said wire is to be welded, contacting the first conductive member to which said wire is to be welded with a second electrode in the welding circuit, passing a welding current between said wire and the said second electrode through said first conductive member to which said wire is to be welded, until said wire is welded to said member, placing a portion of said wire remote from the end of said wire in contact with a second conductive member to which said wire is to be welded, passing a welding current between said second conductive member and said second electrode to weld said portion of the wire to said second conductive member, and cutting said wire to leave a segment of wire welded to and connecting the first and second conductive members.

The attainment of the foregoing and related objects, advantages and features of the invention should be more readily apparent to those skilled in the art, after review of the following, more detailed description of the invention, taken together with the drawings, in which:

BRIEF DESCRIPTION OF THE DRAWINGS:

Figure 1 is a cross-section view of an electrode assembly in accordance with the invention;

Figure 2 is a perspective view of the electrode assembly shown in Figure 1, in use for providing wire-welded connections in a hybrid electronic circuit package;

Figure 3 is a cross-section view taken along the line 3-3 of Figure 2;

Figure 4 is a cross-section view taken along the line 4-4 in Figure 2.

Figure 5 is a front view of a portion of a system in accordance with the invention.

Figure 6 is a top view of the system portion shown in Figure 5.

DETAILED DESCRIPTION OF THE INVENTION:

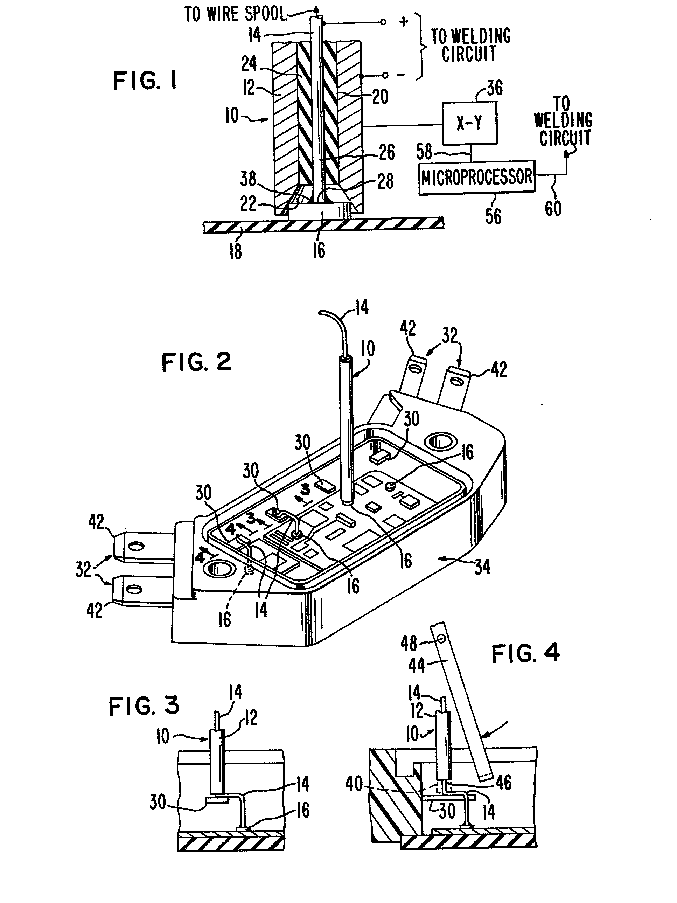

Turning now to the drawings, more particularly to Figure 1, there is shown an electrode assembly 10 in accordance with the invention. The assembly 10 includes an outer, electrically conductive sleeve 12, which is electrically connected as the negative electrode in a conventional welding circuit. While the sleeve 12 can be

. 6.

fabricated of any suitable conductive material, such as copper, it is preferred that the sleeve 12 be as hard as possible, since it must be placed repeatedly in contact with conductive members to which a wire 14 is to be welded, such as nickel-iron weld tab 16, which tab is soldered to a thick film ceramic substrate 18 of the type conventionally employed in electronic packages. For this reason, it is preferred to fabricate the outer, conductive electrode 12 of a carbide steel. Wire 14 may be fabricated of any metal conventionally utilized in welding, such as nickel, steel, stainless steel, aluminum, copper, lead and their alloys. In a preferred embodiment, the wire 14 is nickel or a nickel-copper alloy.

For ease of fabrication, the outer, conductive sleeve 12 has a circular cross-section. The conductive sleeve 12 has an axial passageway 20 extending along the length of the sleeve. The axial passageway terminates in a flared opening 22 at the end of sleeve 12. An insulating sleeve 24 of ceramic or other suitable insulating material, such as sapphire, lines the axial passageway 20 of the conductive sleeve 12. The sleeve 24 should be fabricated of a hard, durable insulating material, since wire 14 will pass through this sleeve. The insulating sleeve 24 terminates at the beginning of the flared opening 22. The insulating sleeve 24 itself has a second, axial passageway 26 extending along its length. The second axial passageway 26 is dimensioned and configured to allow feeding through the electrode assembly 10 of the wire 14 to be welded.

The wire 14 is connected as the positive electrode in a conventional welding circuit of the type employed for wire welding. While the wire 14 may be so connected in any manner, it is preferred to utilize a releasable contact which clamps the wire 14 at the time welding current is to be passed through it, and which releases the wire 14 when the wire 14 is to be fed through the electrode assembly 10 between welds. The wire is chosen as the positive electrode because that electrode is heated to a somewhat higher temperature by current flow between the negative and positive electrodes. In principle, the polarity of the electrodes could be reversed, if desired. Especially if this is done, the metal for the outer, conductive sleeve 12 should have a higher melting point than the melting point of the wire 14. Using a higher melting point metal for the sleeve 12 than for the wire 14 helps assure that the negative electrode sleeve 12 will not stick to the tabs 16 or other metal member to which the wire 14 is welded.

Figure 2 shows the electrode assembly 10 in use for welding wire 14 between nickel-iron weld tabs 16 and ends 30 of terminals 32 of the hybrid electronic circuit package 34. While the circuit package 34 is shown as a four-terminal ignition module employed in automobile engines, it should be recognized that the wire-welding electrode assembly, system and process of this invention can be employed with any electronic package. In a preferred embodiment of the system, the electrode 10 is mechanically connected to a programmable X-Y positioning mechanism 36 (shown in Figure 1), so that the electrode assembly 10 can be successively positioned to weld the wires 14 to their

respective tabs 16 and terminal ends 30 in the module 34. The electrode assembly 10 is also movable upwards and downwards in a vertical direction to move the assembly toward and away from the tabs 16 and ends 30 as the electrode assembly is positioned over them.

In use, the electrode assembly is first positioned on a weld tab 16 as shown in Figures 1 and 2, with the end 28 of the wire 14 in contact with the weld tab 16. A welding current is then passed between the outer, negative electrode 12 of the assembly 10 and the wire 14, constituting the positive electrode of the welding circuit in the electrode assembly 10, by completing a circuit path through the weld tab 16. The welding current is sufficient to cause localized heating and melting at the end 28 of wire 14, thus forming a weld fillet 38 between the wire 14 and weld tab 16 to weld the wire 14 to tab 16. The electrode assembly 10 is then withdrawn from the weld tab 16, and positioned at terminal end 30 for formation of a second weld to connect the wire 14 between the tab 16 and the terminal end 30. Because the wire 14 has been welded to tab 16, a segment of the wire 14 passes through electrode assembly 10 as the assembly 10 is moved between the tab 16 and the terminal end 30. When the electrode assembly 10 is in position so that its outer sleeve 12 and the wire 14 contact the tab 30, welding current is again passed between the negative electrode outer sleeve 12 and the wire 14, through tab 30, to form a second weld. After the second weld has been formed, the wire 14 is cut to separate the remainder of the wire from the segment joining the tab 16 and terminal end 30. The process is then repeated with another tab 16 and terminal end 30. For most metals to be welded, a direct current is typically employed. For aluminum                an alternating current is employed to break up oxides that otherwise interfere with the welding.

The electrode assembly, wire-welding system and process of this invention can be utilized to weld wire interconnections in electronic packages having a wide variety of shapes. However, it is important that the welding tabs 16 and terminal ends 30 not be located in a superimposed relationship. They should be laterally displaced one from another, as shown in Figures 3 and 4, so that the electrode assembly 10 can be positioned on both the welding tabs 16 and the terminal ends 30 from above, as shown in Figure 2.

Figure 3 shows the electrode assembly 10 in position for welding the wire 14 to one of the terminal ends 30. That position is also shown in phantom line at 40 in Figure 4. It should be noted that the wire 14 extends laterally from and beneath electrode assembly 10. The wire 14 is typically bowed upwards slightly along the lateral extension. The wire 14 and outer sleeve 12 may remain as the positive and negative electrodes in the welding circuit if end 22 (Figure 1) of the outer conductive sleeve 12 contacts the wire 14 opposite to contact between wire 14 and terminal end 30. In this case the welding current flow will be directly between the sleeve 12 and the wire 14, but sufficient heating will occur to weld the wire 14 to the terminal end 30. Alternatively, the terminal end 30 may be made one of the electrodes, preferably the negative electrode, and the outer conductive sleeve 12 of the electrode assembly the other electrode, preferably the positive electrode. The terminals 32 may be contacted either at their ends 30 inside the module or their ends 42 (Figure 2), outside the module. It has been determined that no harmful signals are sent to the circuits in such a module when one of the terminals is used as a welding terminal in this manner. Since the terminal ends 30 are near the top of package 34, contact members (not shown) for engaging them may be pivoted into place in a manner similar to that shown in Figure 4 for wire cutting blades 44. If contact is made to the ends 42 of the larger terminals 32, a welding current of 100 watt seconds, the same as would be used for the weld to tab 16, would typically be employed for the larger terminal 32. Since the resistance of the smaller terminals 32 would be higher, a welding current of 125 watt seconds would typically be employed.

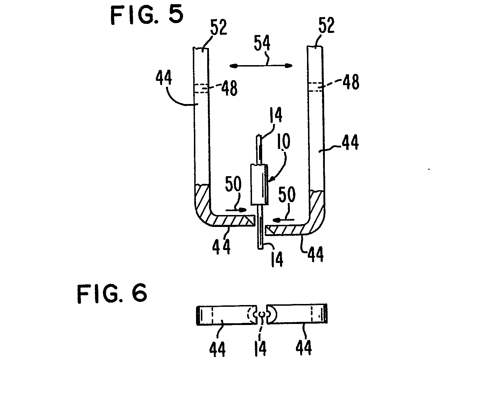

In Figure 4 electrode assembly 10 has been raised slightly to expose a vertical portion 46 of the wire 14. Cutting blades 44 (also shown in Figure 5) are pivoted at 48 to swing them into position on either side of wire 14 and electrode assembly 10 for clipping the wire 14 (see also Figure 6). Blades 44 are then moved toward one another as indicated by arrows 50 to shear the wire 14. This action produces a flat end 28 (Figure 1) on wire 14 for subsequent bonding to a welding tab 16. Such motion may, for example, be produced by moving portions 52 of the blades 44, which portions are above pivots 48, outwards, as indicated by arrow 54. If pivots 48 are provided as gimbals, both the pivoting to position the cutting blades and the pivoting to activate the cutting blades may occur from the same point.

In an especially preferred embodiment of a system in accordance with the invention, the motion of electrode assembly 10, cutting blades 14, the choice of wire 14, outer conductive sleeve 12, and terminals 42 of a module 34 in which the wire welding is to take place as electrodes in the welding circuit, the welding current employed, and the patterns of motion of the electrode assembly 10, the cutting blades 44, and welding electrode contact members to produce wire welds in the module 34 are all programmable. For this purpose, it is desirable to have the XY positioning mechanism 36 connected to the electrode assembly 10 be operated under control of microprocessor 56, connected to the mechanism by line 58, and to the welding circuit by line 60 (Figure 1). Microprocessor 56 may be programmed to control these functions, either in a fixed manner or a variable manner, based on user inputs to the microprocessor 56.

For use with a wire welding process as described above for different packages of the general type of the package 34 shown in Figures 2-4, in which the wire 14 to be welded is used as an electrode for some of the welds, but not for other of the welds, the electrode assembly as shown in Figure 1 may be modified somewhat. For example, three concentric, conductive sleeves or tubes separated from one another by thin insulating layers of several thousandths of an inch may be provided in the assembly. Such conductive sleeves are preferably movable with respect to one another, rotationally in the case of the first two inner conductive sleeves or tubes, and axially as well in the case of the outermost conductive sleeve. In this form, the inner sleeve is used to guide the wire 14 and to make electrical contact to it when the wire is used as an electrode in the welding process. This sleeve may have an insulated end as well to aid in preventing unwanted short circuits to the other conductive sleeves when the wire is used as an electrode. In this modified form, the second conductive sleeve takes the form of the sleeve 12 shown in Figure 1. The third conductive sleeve desirably has wire receiving notches in its tip, giving the tip a crenellated configuration to assist in controlling the positioning of the wire for its second weld. Rotational motion of the conductive sleeves in this embodiment relative to each other, and vertical motion of the third, outer sleeve relative to the other two sleeves, are both desirably controlled by the microprocessor.

As an alternative to cutting blades 44 which provide a shearing action, other types of cutting blades may be employed, which will produce a pointed end on the wire 14. If this is done, a higher welding current should be employed to melt such a peak, in order to obtain a flat end on the wire for good welds.

For forming some welds, it is also desirable to supply a lower, preheating current to the wire. This current will heat the wire and the conductive member to which the wire is to be welded, but not to a welding temperature. Subsequent application of the welding current to the wire will then result in better sticking of the wire to the member to which it is welded.

It should now be apparent to those skilled in the art that a novel, wire-welding electrode assembly, wire-welding system and process capable of achieving the stated objects of the invention has been provided. By making the wire to be welded one of the electrodes in the welding circuit, the necessity to dress the electrodes to prevent electrode sticking is eliminated. In fact, sticking of the wire to the member to which it is to be welded is desired, rather than eliminated. Elimination of one of the electrodes conventionally provided for wire welding also means that the electrode assembly of this invention is smaller than conventional parallel gap wire-welding electrode assemblies. This characteristic is of special value in the wire welding of connections in electronic packages, due to size constraints.

It should be further apparent to those skilled in the art that various changes in form and details of the invention as shown and described may be made. For example, rather than moving the electrode assembly with respect to the circuit package, as described above, the electrode assembly 10 may remain stationary, and the electronic circuit package 34 positioned through use of an X-Y positioning mechanism to place the weld tabs and terminal ends 30 successively beneath the stationary electrode assembly. It is intended that such changes be included within the spirit and scope of the claims appended hereto.

WHAT IS CLAIMED IS:

1. A wire-welding system characterized by: an electrode assembly which comprises an outer conductive sleeve having an axial passageway, and guide means for a wire in said axial passageway, said guide means electrically insulating the wire from said outer conductive sleeve; a welding circuit electrically connected to said electrically conductive sleeve and to the wire to be welded, the connection to the wire permitting the wire to be fed through said electrode assembly; means for positioning a member to which the wire is to be welded with respect to said electrode assembly; and means for supplying the wire to be welded for passage through said electrode assembly.

2. The system of Claim 1 characterized in that said wire comprises nickel.

3. The system of Claim 1 or 2 characterized in that said member to which said wire is to be welded comprises a part of an electronic circuit package, there are a plurality of such members in the circuit package, and said means for positioning successively positions each of the plurality of members with respect to the electrode assembly for welding of the wire to each of the members in succession.

4. The system of Claim 3 characterized by means for cutting the wire after the wire has been welded between two of the members to be electrically connected in the circuit package.

5. A wire-welding process, characterized by electrically connecting the wire to be welded as a first electrode in a welding circuit;

positioning an end of said wire to be welded on a first conductive member to which said wire is to be welded, contacting the first conductive member to which said wire is to be welded with a second electrode in the welding circuit;

passing a welding current between said wire and the said second electrode through said first conductive member to which said wire is to be welded, until said wire is welded to said member;

placing a portion of said wire remote from the end of said wire in contact with a second conductive member to which said wire is to be welded;

passing a welding current between said second conductive member and said second electrode to weld said portion of the wire to said second conductive member, and

cutting said wire to leave a segment of wire welded to and connecting the first and second conductive members.

6. An electrode assembly for wire welding, characterized by an outer conductive sleeve having an axial passageway, and guide means for a wire in said axial passageway, said guide means electrically insulating the wire from said outer conductive sleeve.

1/2

TO WIRE SPOOL

FIG. 1

TO WELDING CIRCUIT

X-Y 36

MICROPROCESSOR

TO WELDING CIRCUIT

FIG. 2

FIG. 3

FIG. 4

FIG. 5

FIG. 6